# EUROPEAN PATENT APPLICATION

(11) **EP 3 270 468 A1**
(43) Date of publication of application: **17.01.2018**
(21) Application number: 16178943.3
(22) Date of filing: 12.07.2016
(51) Int. Cl.: H01R 13/66, H01R 39/64, H05K 1/18, H01R 39/08, H01R 39/24, H01R 43/10, H01R 24/60, G08B 13/196

(54) **SLIP RING ASSEMBLY**

(71) Applicant: Axis AB, 223 69 Lund (SE)
(72) Inventor: Bergström, Jonas, 223 61 Lund (SE); Hallberg, Niklas, 222 40 Lund (SE); Svedberg, Henrik, 246 32 Löddeköpinge (SE); Nordgren, Viktor, 234 40 Lomma (SE); Lilieblad, Martin, 224 74 Lund (SE); Bergfors, Kristian, 245 62 Hjärup (SE); Svensson, Sven, 244 66 Furulund (SE); Persson, Johan, 268 73 Billeberga (SE); Helaoui, Samir, 211 50 Malmö (SE); Pahlitzsch, Jens, 224 57 Lund (SE); Sandström, Oscar, 211 25 Malmö (SE); Frohlund, Stig, 281 38 Hässleholm (SE); Svärd, Glenn, 256 61 Helsingborg (SE); Birch, Magnus, 233 35 Svedala (SE); Hovmøller, Henrik, 4300 Holbæk (DK)
(74) Representative: Awapatent AB

(57) **Abstract**

The present invention relates to a slip ring assembly (10) for transfer of electrical signals across a rotatable mechanical connection. The slip ring assembly (10) comprises a first element (12) rotatably connected to a second element (14) by means of a mechanical, rotatable connection (42, 44, 52, 54, 56, 58), a plurality of electrically conducting signal paths, each forming an electrical signal path between a connecting terminal (18) on the first element (12) and a connecting terminal (22) on the second element (14) to transfer a signal over the mechanical, rotatable connection (42, 44, 52, 54, 56, 58) between the first and second elements (12, 14), each electrically conducting signal path includes an electrically conducting ring (34) arranged in the first element (12) and a brush (48) arranged in the second element (14), the ring (34) and the brush (48) of an electrically conducting signal path are in electrical contact for transferring electrical signals from the first element (12) to the second element (14) or vice versa, and the electrically conducting rings (34) of the electrically conducting signal paths are arranged coaxially in relation to an axis of rotation (16) of the mechanical, rotatable connection (42,44, 52, 54, 56, 58). Further, the electrically conducting signal paths from the connecting terminal (18) on the first element (12) to the electrically conducting ring (34) being formed as electrically conducting tracks (30) on a printed circuit board (20) and, each electrically conducting ring (34) being mounted directly on and in direct connection with corresponding electrically conducting tracks (30) on the printed circuit board (20).

## Description

### Technical field of the invention

The present invention relates to a slip ring assembly for transfer of electrical signals across a rotatable mechanical connection.

### Background of the invention

Slip ring assemblies are commonly used in electronic devices comprising rotating parts and where electrical signals and/or power is to be transferred over a rotational joint of the device. One use of such slip rings is in pan and/or tilt enabled cameras in which a camera head has to be rotationally connected to another part of the camera body and still be able to receive power, transmit video data, and receive and transmit control data, settings and parameters. Slip rings are advantageously used in systems where the rotating parts is going to be rotated more than 360 degrees in relation to each other and even more advantageous when the relative rotation comprises multiple rounds.

In a commonly implemented design a slip ring includes electrically conducting brushes attached to a stationary or rotational part and electrically conducting rings attached to a rotational or stationary part. In some slip ring assemblies both the part with the brushes and the part with the rings may be rotational. In any case, the two parts are arranged to be rotated in relation to each other, independent of if one or both of them are rotatable. For sake of simplicity the two parts will be referred as stationary part and rotational part in this background. Each ring is electrically interacted with by one or a plurality of brushes and each brush is arranged to stay in electrical contact with an electrically conducting ring during substantially all rotational movement between the two parts. An electrical wire is soldered to each electrically conducting ring forming a wire bundle and the wire bundle is connected to an electrical interface on the rotational side of the slip ring. On the stationary side electrical wires are soldered to the brushes and are connected to an electrical interface on the stationary side of the slip ring. These and other manufacturing aspects of slip rings makes it laborious and expensive to manufacture slip rings. Moreover, the common design of the slip rings makes it difficult to automate the manufacturing process.

Such problems with slip rings are addressed in patent application GB 2504368 by forming the rotational part from a substrate material, e.g. a printed circuit board, through which brush wires are arranged and arcing outwards in order to interact with an inner perimeter of a ring. The rings are stacked using racks having groves for receiving the outer perimeter of the rings and arrange the rings at proper distance from each other. The racks holds the stack of rings together and the printed circuit board holding the brush wires are inserted into the cylinder formed by the stack of rings.

WO 2013/030563 describes solving problems relating to automating the manufacturing process. Moreover, the application teaches how to design a slip ring allowing high bandwidth throughput. A slip ring including a first component and a second component which are rotatable relative to each other is described. The first component has a body formed from a plurality of conductive grooved rings separated by insulating rings. Wherein the conductive grooved rings each are connected to a buffer/amplifier mounted on a circuit board which at least partly is arranged within a cylinder formed from the conductive grooved rings. Each buffer/amplifier is connected to a corresponding grooved ring via a separate conductive link arranged between the circuit board and the grooved ring. The conductive links should all have the same length.

Even if the state-of-the-art presents designs facilitating manufacturing of slip rings these designs may be further improved in order to simplify manufacturing even more.

### Summary of the invention

One object of the present invention is to provide an alternative slip ring design that may simplify manufacturing of slip rings.

The object is achieved by means of a slip ring assembly according to claim 1. Further embodiments of the invention are presented in the dependent claims.

More specifically, according to one embodiment of the invention, a slip ring assembly for transfer of electrical signals across a rotatable mechanical connection comprises a first element rotatably connected to a second element by means of a mechanical, rotatable connection, a plurality of electrically conducting signal paths, each forming an electrical signal path between a connecting terminal on the first element and a connecting terminal on the second element to transfer a signal over the mechanical, rotatable connection between the first and second elements, and each electrical signal path includes an electrically conducting ring arranged in the first element and a brush arranged in the second element the ring and the brush of an electrical path are in electrical contact for transferring electrical signals from the first element to the second element or vice versa, the electrically conducting rings of the electrical signal paths are arranged coaxially in relation to an axis of rotation of the mechanical, rotatable connection. Further, the electrical paths from the connecting terminal on the first element to the electrically conducting ring being formed as electrically conducting tracks on a printed circuit board and, each electrically conducting ring being mounted directly on and in direct connection with corresponding electrically conducting tracks on the printed circuit board. One advantage from the conducting rings being mounted directly in contact with conducting tracks on the PCB, which conducting tracks forms the electrical paths from the conducting rings to the connecting terminals, is that the manufacturing process of the slip ring assembly becomes simplified and the number of steps required in manufacturing of the slip ring assembly may be decreased.

In some embodiments the printed circuit board comprises at least one layer of conducting tracks and at least one non-conducting substrate forming support for the conducting tracks, wherein each conducting ring is attached to the edge of the printed circuit board and in direct electrical contact with a corresponding conducting track on the printed circuit board. A possible advantage with these features is that the manufacturing of the first element of the slip ring is simplified and that a resulting first element may become robust due to few parts and tightly integrated arrangement.

The conducting rings encircles a portion of the printed circuit board of the first element. This arrangement may further increase the robustness of the first element both in the manufacturing process and as a part of the slip ring. Moreover, this feature also facilitates the manufacturing of the slip ring assembly in that the brushes may be arranged to connect to the outside perimeter of the conducting rings.

In some embodiments the connecting terminals on the first element for the electrical paths are arranged on the printed circuit board at an edge not encircled by the conducting rings. One advantage of this arrangement is easy access to the conducting path through the slip ring and another is that it simplifies the process of connecting the slip ring to the system it supposed to be a part of.

The connecting terminals of the first element may be arranged side by side along the edge of the printed circuit board. Which may be advantageous in that the connecting to the system may be further simplified as the PCB may form a connector that may interact with connectors in a slot or other type of interface means arranged in the system that the slip ring is to be connected to.

Further, the connecting terminals of the first element may be arranged in a first group and in a second group of connecting terminals. The connecting terminals within each of the two groups may be arranged side by side along the edge of the printed circuit board. The connecting terminals (18) of the first group may be arranged on a first surface of the printed circuit board (20) and the connecting terminals of the second group may be arranged on a second surface of the printed circuit board. The first surface being a surface on an opposite side of the printed circuit board in relation to the second surface.

In some embodiments the electrically conducting tracks forming the electrical paths on the printed circuit board of the first element are of essentially the same length. By making the electrical paths essentially of the same length the electrical characteristics of the slip ring as a transmission path may be improved.

In yet other embodiments each of the conducting rings is attached to the edge of the printed circuit board at an individual edge plating, each being part of a conducting track on the printed circuit board. Moreover, the brushes of the second element may be brush wires.

Further, each electrical conducting signal path of the second element may be connected to two brush wires, wherein the two brush wires of the same electrical conducting signal path are arranged to engage with the same electrically conducting ring of the first element. This is advantageous from an electrical point of view in that the electrical characteristics of the transmission path may vary less and is thereby improved in view of a single brush path.

In some embodiments the space encircled by the electrically conducting rings and the space between the rings is occupied by a non-conducting rigid material which in addition extends in the direction of the rotational axis forming an axle for rotational engagement with the second element and thereby forming a rotatable mechanical connection. Thereby the manufacturing process of the first element and the entire slip ring may be simplified.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description. Hence, it is to be understood that this invention is not limited to the particular component parts of the device described or steps of the methods described as such device and method may vary. It is also to be understood that the terminology used herein is for purpose of describing particular embodiments only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a sensor" or "the sensor" may include several sensors, and the like. Furthermore, the word "comprising" does not exclude other elements or steps.

### Brief description of the drawings

Other features and advantages of the present invention will become apparent from the following detailed description of a presently preferred embodiment, with reference to the accompanying drawings, in which
Fig. 1 is a perspective view of an assembled slip ring assembly in accordance with some embodiments of the invention,
Fig. 2 is a perspective view of a first element of the slip ring assembly without a structure forming material molded onto it,
Fig. 3a is a schematic view of the electrical paths on a first side of a PCB of the first element of Fig. 2,
Fig. 3b is a schematic view of the electrical paths on a second side of a PCB of the first element of Fig. 2,
Fig. 4 is a section view of the first element of Fig. 2 including the structure forming material,
Fig. 5 is a perspective view of a portion of the second element 14 including the electrical paths of the second element,
Fig. 6 is an exploded view of the assembled slip ring assembly of Fig. 1,
Fig. 7a shows an end view of a base used for making brush wires for the second element of Fig. 5 having a brush wire wound around it in a first step of making the brush wires,
Fig. 7b shows a side view of the base in Fig. 7a, this side view represent either side as they would look the same,
Fig. 7c shows a top view of the base in Fig. 7a,
Fig. 7d shows a bottom view of the base in Fig. 7a,
Figs 8a-b shows an end view of the base and the wound brush wire in a second and third step of making the brush wire, and
Fig. 9 shows a finished brush wire pair for mounting in the second element showed in Fig. 5.

Further, in the figures like reference characters designate like or corresponding parts throughout the several figures. Moreover, references presented in the figures as a numeric value and a letter, e.g. 30a, 30b, 30c, 30d, etc., are intended to refer to similar parts or features. When any one of such parts or features or all the features in this type of range is referred to in the description only the numeric value is used as a reference, e.g. 30 refers to any one or all of 30a, 30b, 30c, 30d, etc.

### Detailed description of embodiments

The present invention relates to a slip ring assembly for transfer of electrical signals over a rotational joint in an electrical device. The electrical signals transferred over the slip ring may be electrical power to power a device on a receiving side of the slip ring, control data or instructions, sensor data, image data, video signals, video data, audio signals, audio data, etc.

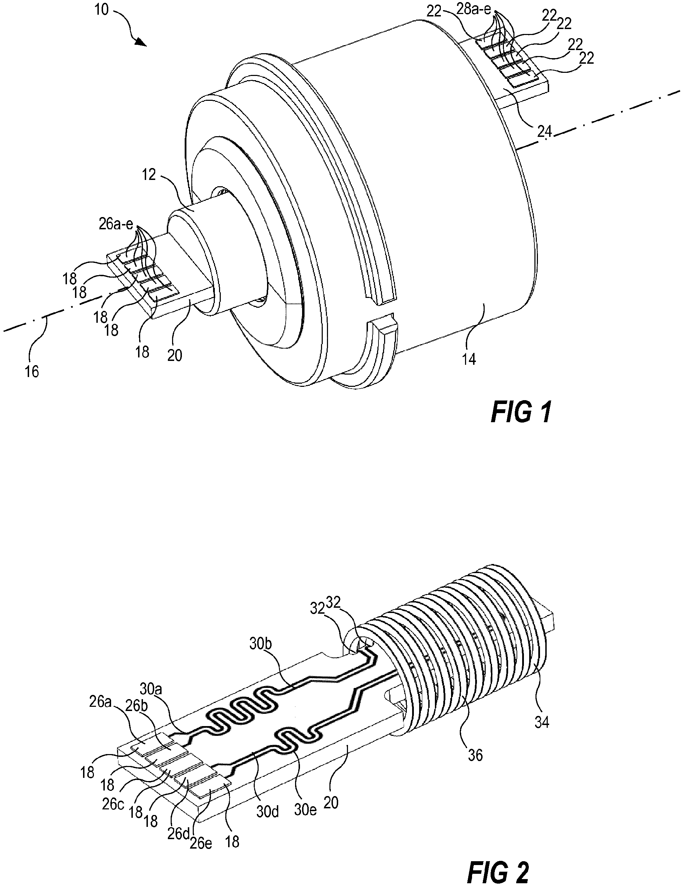

In Fig. 1 an exemplary embodiment of a slip ring assembly 10 according to the invention is showed. The slip ring assembly 10 includes two main elements, a first element 12 and a second element 14, which are arranged to be rotatable relative to each other around a rotational axis 16. An electric signal path is provided between a connecting terminal 18, on a printed circuit board 20 (PCB) of the first element 12, and a connecting terminal 22, on a PCB 24 of the second element 14. The connecting terminal 18 and/or the connecting terminal 22 may be arranged to be connected to circuitry on its side of the rotational joint through direct connection of wires by means of soldering, by clamping or by any other fastening method, or may include an exposed contact area, 26a-e, 28a-e, for each electric signal path as showed in the figures. These contact areas, 26a-e, 28a-e, may then be arranged side-by-side along an edge of the PCB 20, 24. Corresponding contact areas for additional signal paths may be arranged at a corresponding location but on the opposite surface of the PCB. This later type of connecting terminal may then simply plug into a receiving interface in respective device, i.e. on each side of the rotational joint.

Now referring to Fig.2 showing features of the first element 12. In the example embodiment the first element 12 may be referred to as the rotor of the slip ring assembly 10 as it is this element that is arranged to be rotated. As mentioned above the first element 12 includes a PCB 20, connecting terminals 18, conducting tracks 30a-e, edge platings 32, and electrically conducting rings 34. The PCB 20 may be any type of PCB providing an electrical signal path between each connecting terminal 18 and an electrically conducting ring 34 in the form of a conducting track 30. Each conducting track ends in an edge plating 32 to which the electrically conducting ring 34 of that specific electrical signal path is soldered. Alternately the conducting tracks 30 ends with a non-insulated track portion at the edge of the PCB where the electrically conducting rings 34 is to be arranged. In this latter alternative the electrically conducting rings are soldered to the non-insulated track portion. The electrically conducting rings 34 is provided with a groove 36 along the outer perimeter of the ring intended to accommodate a brush wire protruding from the second element, brush wires will be described in more detail below.

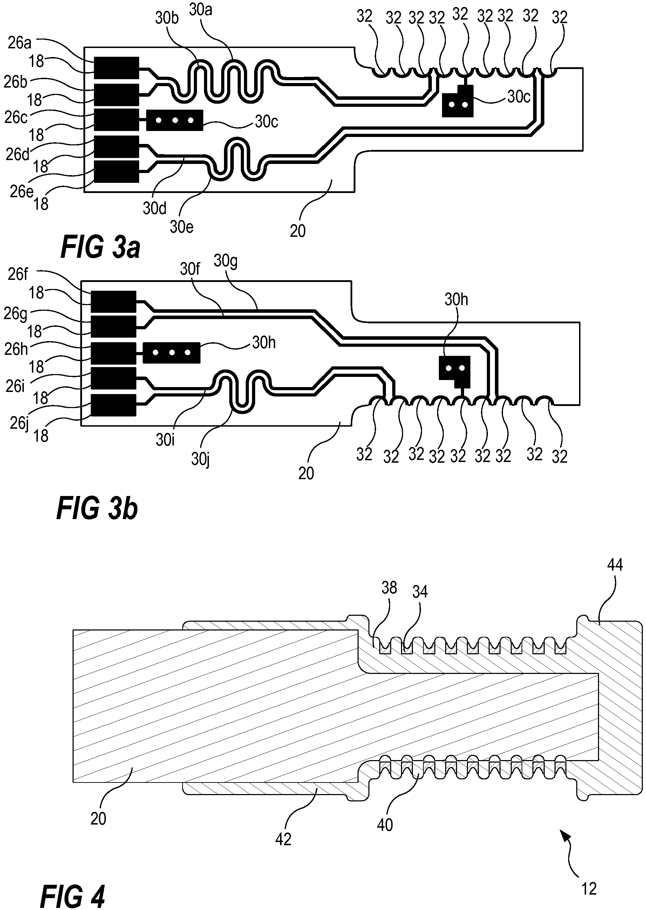

The PCB may be a rigid three layered PCB having eight signal paths arranged on two layers and ground on the third layer. Alternatively, the PCB may be a two layered PCB having eight signal paths arranged on one layer and ground on the other layer. However, the PCB may be of any number of layers as long as the necessary number of signal paths may be provided. The conducting tracks 30a-j for each individual signal path are more clearly illustrated in Figs 3a-b. In order to improve the electric characteristics of the slip ring 10, the length of the signal paths are substantially equal. This is achieved by introducing extra turns on the conducting tracks 30 which otherwise should be shorter. In the example embodiment if Figs 3a-b a ground path 30c, 30h, is implemented by having one terminal on each side of the PCB connect to the ground plane of the PCB and by having one of the edge platings 32 connect to the ground plane in order to allow the ground path 30c, 30c to continue through the slip ring 10.

In Fig. 4 the first element 12 is shown in a cross sectional view and with the addition of an isolating and structure forming material 38. This material 38 may be any electrically isolating material having enough structural integrity to support bearings arranged between the first and second elements or having properties allowing it to form part of a bearing 42, 44 between the first and second elements 12, 14, and /or support separate bearings arranged between the first and the second elements 12, 14. This material 38 may be some form of polyamide material or any other material known by the skilled person to allow low pressure injection moulded and present the characteristics presented above. The material 38 may have properties allowing it to be injection moulded into a mould holding the PCB 24 with the electrically conducting rings 34 mounted onto the PCB 24, e.g. using low pressure injection moulding. The material 38 is formed so that it gives stability to the first element, electrical insulation 40 between the electrically conducting rings, a proximal bearing surface 42, closest to the connecting terminals 18, and a distal bearing surface 44, further away from the connecting terminals 18. The bearing surfaces may be formed to interact with bearing surfaces of the second element 14 for facilitating the rotation of the first element 12 in relation to the second element 14 or to support separate bearings, e.g. ball bearings, arranged between the first and second elements 12, 14.

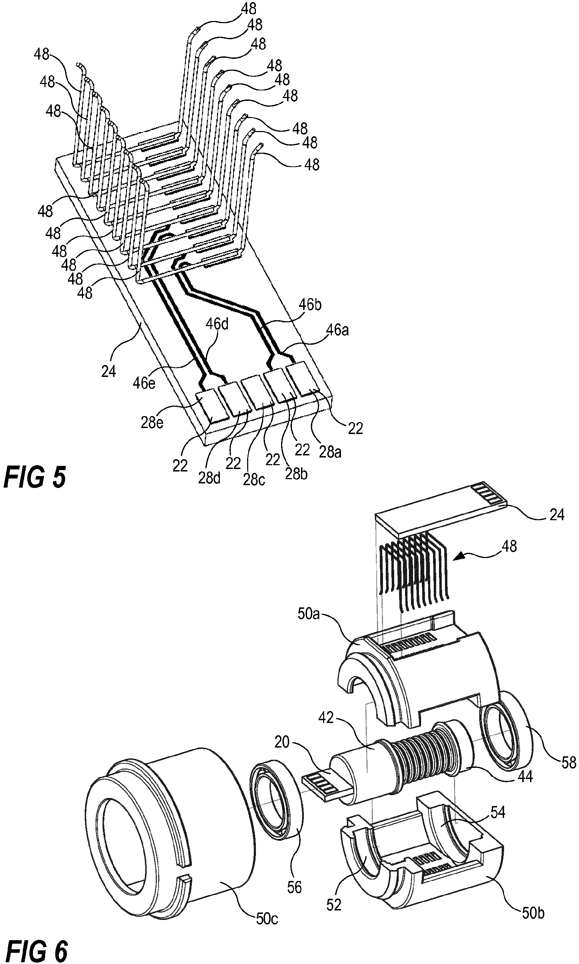

The second element 14, according to the example embodiment, is also based on a PCB 24 on which the connecting terminals 22 are arranged at an edge of the PCB 24 for facilitating connecting the terminals 22 to a circuitry sending and/or receiving signals over the slip ring assembly 10, see Fig. 5. Various embodiments of the contact terminals has been described previously in connection with the contact terminals 18 of the first element 12. The PCB used for the second element 14 may be of the same type as used for the first element 12. However, alternatively the PCB may be of any known types and may also be of a type different than the one used for the first element 12.

Further, the PCB 24 of the second element 14 includes conducting tracks 46 forming an electrical signal path from each of the connecting terminals to a corresponding brush 48. The brushes 48 may be wires having good conductive properties and which are arranged in pairs, wherein each pair interact with one conductive ring 34 of the first element 12. Each pair of brushes 48 is incorporated into the electrical signal path by means of connecting to a conducting track 46. The brush wires 48 may be made from an alloy of silver and copper. However, other materials, known by the skilled person, may be used for forming the brush wires 48. The brush wires 48 are arranged in a row so that a first brush wire 48 in each brush wire pair are arranged next to each other and a second brush wire 48 in each brush wire pair are arranged next to each other. The distance between brush wires 48 of different brush wire pairs corresponds to the distance between electrically conducting rings 34 in the first element 12.

Now referring to Fig. 6, the second element 14 further includes a housing 50. The housing 50 forms bearing surfaces 52 and 54 arranged to interact with the bearing surfaces 42 and 44 of the first element 12 or to support ball bearings 56, 58. The housing 50 may be formed from three separate parts, one first housing inner part 50a, one second housing inner part 50b, and one housing outer of part 50c. The PCB of the second element 14 is arranged between the first housing inner part 50a and the housing outer part 50c. The brush wires 48 protrudes through the first housing inner part 50a in order to interact with the conducting rings 34 of the first element 12.

In one embodiment a ball bearing 56 is arranged between one bearing surface 42 of the first element 12 and one bearing surface 52 of the second element 14. Moreover, in this embodiment a ball bearing 58 is arranged between the other bearing surface 44 of the first element 12 and the other bearing surface 54 of the second element 14. However the bearing arrangement between the first element 12 and the second element 14 may be of any type suitable for the application of the slip ring assembly 10. For example the bearing arrangement could be a journal bearing, bushing, ball bearing, roller bearing liquid bearing, magnetic bearing, etc.

Now referring to figures 2 and 4, one way of producing the first element 12 is to make a PCB 20 having the desired conducting tracks 30a-e, the contact areas 26a-e, and the edge platings 32. This PCB 20 is produced in accordance with normal PCB making processes well known by the person skilled in the art. Then, each of the electrically conducting rings 34, having a grove 36 in the outer perimeter of the ring, is arranged in a slot formed in the edge of the PCB and is soldered to edge platings 32 of these slots. When the rings 34 are soldered in place the PCB 20 having the rings attached is fixed in a tool for injection molding. The tool is formed so that the features described above in connection with the first element 14 are formed by the material injected into the tool or mold. Then the first element is ready to be mounted in a slip ring arrangement 10.

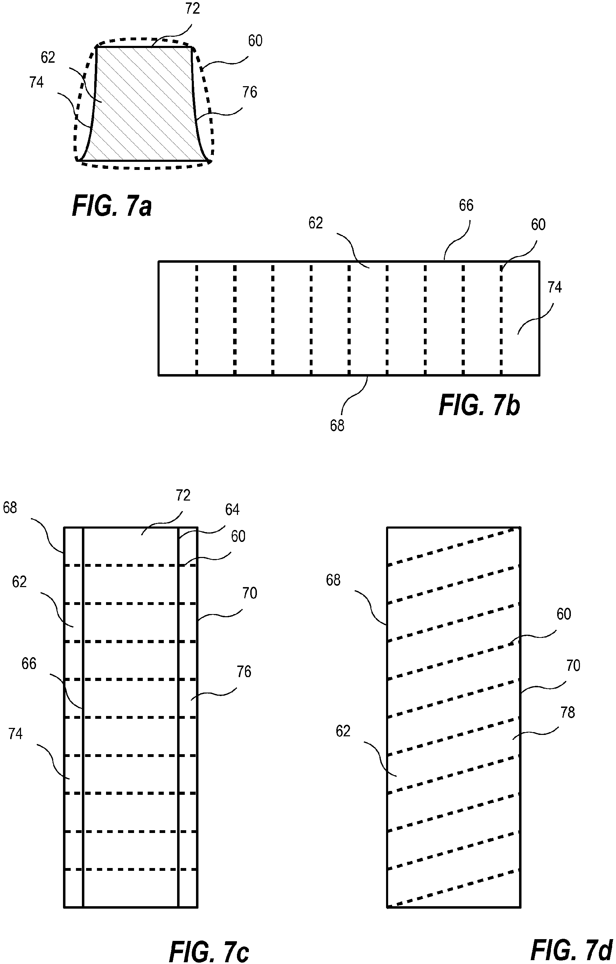

The brush wires 48 for the second element may be produced by winding of a long wire 60 of brush wire material onto a base 62, see Figs 7a-d. As seen in Figs. 7a-c the long wire 60 is wound around the base 62 so that the wire is perpendicular to long edges 64, 66, 68, 70 of the base 62 along a top surface 72, a first side surface 74, and a second side surface 76. Then along a bottom surface 78 of the base the long wire 60 is arranged diagonally to start a new perpendicular passage of the two side surfaces 74, 76 and the top surface 72.

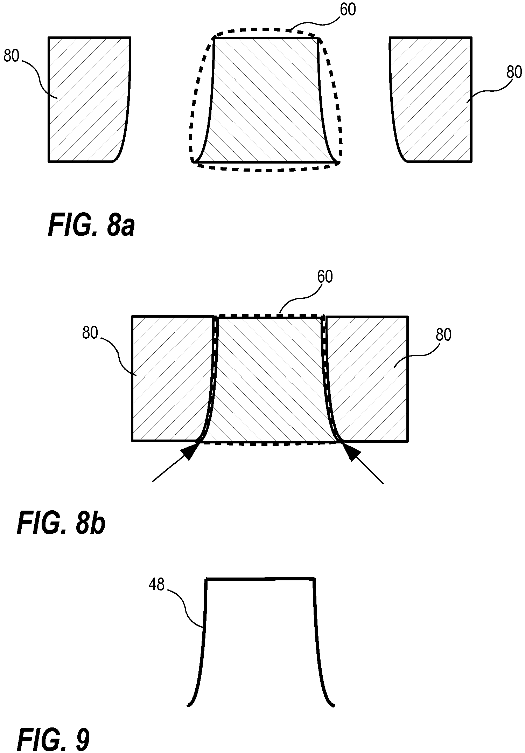

Each of the wire passages that is perpendicular to the long edges 64, 66, 68, 70, will form a separate brush wire 48 in the second element 14. In order to shape the brush wires 48 a press tool 80 formed to substantially complement the shape of the two side surfaces 74 and 76 of the base 62 are pressed against the base 62 having the long wire 60 wound around it as described above, see Figs 8a-b. In this way the characteristic shape of the brush wires may be formed. Then the long wire 60 may be cut along the long edges 68, 70, of the base at the bottom surface 78, indicated by the arrows in Fig. 8b, leaving a number of brush wires that are ready to be mounted on the PCB 24 of the second element 14. The brush wires 48 may alternatively be mounted to the PCB 24 of the second element before the pressing by the press tool 80 and the cutting of the long wire 60. Then the brush wires 48 are already mounted when the pressing and cutting is performed, which may simplify the mounting of the brush wires. In another embodiment the long wire is pressed into the desired shape before the long wire is mounted on the PCB 24 and then the cutting is performed after mounting. This method will also simplify the mounting of the brush wires 48. The mounting of the brush wires 48 may, for example, include soldering each brush wire 48 to a conductive track 46 on the PCB 24 of the second element 14.

A slip ring assembly as described in any of the embodiments above may be used in a pan tilt enabled networked video camera in order to enable unlimited rotation of a camera head in relation to the camera base. The power to the camera head and control signals to and from the camera head and video data from the camera head may then be transferred via the slip ring assembly 10. The slip ring assembly may be arranged in the panning axis, in the tilting axis, or in both the panning and the tilting axis of the camera.

## Claims

1. Slip ring assembly (10) for transfer of electrical signals across a rotatable mechanical connection, the slip ring assembly (10) comprising:
a first element (12) rotatably connected to a second element (14) by means of a mechanical, rotatable connection (42, 44, 52, 54, 56, 58),
a plurality of electrically conducting signal paths, each forming an electrical signal path between a connecting terminal (18) on the first element (12) and a connecting terminal (22) on the second element (14) to transfer a signal over the mechanical, rotatable connection (42, 44, 52, 54, 56, 58) between the first and second elements (12, 14),
each electrically conducting signal path includes an electrically conducting ring (34) arranged in the first element (12) and a brush (48) arranged in the second element (14), the ring (34) and the brush (48) of an electrically conducting signal path are in electrical contact for transferring electrical signals from the first element (12) to the second element (14) or vice versa,
the electrically conducting rings (34) of the electrically conducting signal paths are arranged coaxially in relation to an axis of rotation (16) of the mechanical, rotatable connection (42,44, 52, 54, 56, 58),
**characterised by**:
the electrically conducting signal paths from the connecting terminal (18) on the first element (12) to the electrically conducting ring (34) being formed as electrically conducting tracks (30) on a printed circuit board (20) and,
each electrically conducting ring (34) being mounted directly on and in direct connection with corresponding electrically conducting tracks (30) on the printed circuit board (20).

2. Slip ring assembly (10) according to claim 1, wherein the printed circuit board (20; 24) comprises at least one layer of conducting tracks (30; 46) and at least one non-conducting substrate forming support for the conducting tracks (30; 46), wherein each conducting ring (34) is attached to the edge of the printed circuit board and in direct electrical contact with a corresponding conducting track (30; 46) on the printed circuit board (20; 24).

3. Slip ring assembly (10) according to any one of claims 1 or 2, wherein the conducting rings (34) encircles a portion of the printed circuit board (20) of the first element (12).

4. Slip ring assembly (10) according to any one of claims 1-3, wherein the connecting terminals (18) on the first element (12) for the electrically conducting signal paths are arranged on the printed circuit board (20) at an edge not encircled by the conducting rings (34).

5. Slip ring assembly (10) according to claim 4, wherein the connecting terminals (18) of the first element (12) are arranged side by side along the edge of the printed circuit board (20).

6. Slip ring assembly (10) according to claim 4, wherein the connecting terminals (18) of the first element is arranged in a first group and in a second group of connecting terminals (18), the connecting terminals (18) within each of the two groups are arranged side by side along the edge of the printed circuit board (20), the connecting terminals (18) of the first group are arranged on a first surface of the printed circuit board (20), the connecting terminals (18) of the second group are arranged on a second surface of the printed circuit board, and the first surface being a surface on an opposite side of the printed circuit board in relation to the second surface.

7. Slip ring assembly (10) according to any one of claims 1-6, wherein the electrically conducting tracks (30) included in the electrically conducting signal paths on the printed circuit board (20) of the first element (12) are of essentially the same length.

8. Slip ring assembly (10) according to any one of claims 1-7, wherein each of the conducting rings (34) is attached to the edge of the printed circuit board (20) at an individual edge plating (32), each being part of a conducting track (30) on the printed circuit board (20).

9. Slip ring assembly (10) according to any one of claims 1-8, wherein the brushes (48) of the second element (14) are brush wires (48).

10. Slip ring assembly according to claim 9, wherein each electrically conducting signal path of the second element (14) is connected to two brush wires (48), wherein the two brush wires (48) of the same electrically conducting signal path are arranged to engage with the same electrically conducting ring (34) of the first element (12).

11. Slip ring assembly (10) according to any of claims 1-10, wherein the space encircled by the electrically conducting rings (34) and the space between the rings is occupied by a non-conducting rigid material (38) which in addition extends in the direction of the rotational axis forming an axle for rotational engagement with the second element (14) and thereby forming a rotatable mechanical connection.

12. Slip ring assembly (10) according to claim 11, wherein the rotatable mechanical connection between the first element (12) and the second element (14) comprises ball bearings (56, 58) interacting with the bearing surfaces (42, 44) of the first element (12) and the bearing surfaces (52, 54) of the second element (14).

13. A network enabled video camera having pan tilt functionality including the slip ring assembly 10 according to any one of claims 1-12.
